# EUROPEAN PATENT APPLICATION

(11) **EP 0 767 492 A2**
(43) Date of publication of application: **09.04.1997**
(21) Application number: 96306494.4
(22) Date of filing: 06.09.1996
(51) Int. Cl.: H01L 21/66

(54) **Integrated circuit test system**

(30) Priority: 02.10.1995 US 537596
(71) Applicant: ALTERA CORPORATION, San Jose, California 95134-2020 (US)
(72) Inventor: Cliff, Richard G., Milpitas, California 95035 (US)
(74) Representative: Cross, Rupert Edward Blount

(57) **Abstract**

Die are fabricated using a technique commonly known as "flip-chip." The die are then tested in a test device. Only a subset of the contact pads (201) on the flip-chip are used in the testing process. In a most preferred embodiment each of the subset of pads on the flip-chip are connected by metalization (204) or otherwise to probe pads (205) on the periphery of the flip-chip device. These probe pads are used in a test device to apply selected signals to the device and test its performance.

## Description

### BACKGROUND OF THE INVENTION

The present invention relates to the field of integrated circuits and their manufacture. More specifically, in one embodiment the invention provides an improved manufacturing test system for such integrated circuits.

In the field of integrated circuit manufacture, testing systems are widely used. In a typical operation, many individual devices are fabricated on a number of die on a larger wafer. Each die is eventually separated from the wafer by sawing or other operations and then placed in a package.

During the manufacturing process, it is important to test the various die while they are still in wafer form to ensure that they operate in an expected or desired manner. One important test operation is normally performed after fabrication of the various die is complete, but before the die are separated. In such testing operations, the wafer is "probed" by a wafer prober. In operation, the wafer prober contacts each individual die with a probe card. Various electrical signals are applied to the die via electrical contact pads on the die, and the response of the die is monitored. If the die is functional, it is passed, and if the die is not functional, it is typically marked by an inker, or otherwise identified as inadequate.

In traditional semiconductor devices the electrical contacts for the die are arranged around the periphery of the die. A peripheral arrangement for the contacts allows easy access to the contacts with a probe card made using current probe-card technology that is well known in the art. These contacts are used not only for test operations, but also are used later in the manufacturing operation during packaging for contact to the outside world. As integrated circuits become increasingly complex, however, alternative techniques have been proposed for arranging and packaging integrated circuits. One common technique for arranging the contacts to interface with the outside world from an integrated circuit is referred to as "flip-chip." A flip-chip integrated circuit includes a plurality of devices fabricated on one side of a wafer. The contact pads for the integrated circuit are not arranged around the periphery of the die, but instead are arranged as an array of solder bumps, for example, extending from the face of the device.

Flip-chip devices have a variety of advantages over conventionally-made die. Testing flip-chip integrated circuits, however, presents challenges. In particular, as integrated circuits require greater numbers of input, output, and input/output pins (in some cases today, 1000 or more), the mechanics and operational problems encountered in testing such flip-chip devices have become problematic. For example, probing an array of contact pads, instead of just a periphery of pads, requires a more complex, more expensive, probe card. This arrangement causes the probe card to have a higher failure rate than traditional, simpler probe cards.

From the above it is seen that an improved device and system for manufacturing integrated circuits is needed.

### SUMMARY OF THE INVENTION

An improved method of manufacturing integrated circuits is provided by virtue of the present invention.

According to one aspect of the invention, a plurality of die are fabricated on a wafer. The die are fabricated using a technique commonly known as "flip-chip," as described in greater detail in, for example, Fink et al., The Electrical Engineers' Handbook, pg. 7-84, incorporated by reference for all purposes. The die are then tested in a test device before wafer dicing. According to one aspect of the invention, only a subset of the pads on the flip-chip are used in the testing process. In a most preferred embodiment, each of the subset of pads on the flip-chip are connected by metalization or otherwise to probe pads on the periphery of the flip-chip device. These probe pads are used in more conventional test devices to apply selected signals to the device and test its performance.

According to a specific embodiment of the invention, the process for making a semiconductor device includes the steps of forming a plurality of die in a wafer, the die comprising an array of connection points in a flip-chip configuration; forming a connection to a portion of the connection points in a die with a wafer prober, the portion of the connection points arranged in a periphery of the connection points; and testing the die, the die selected if it passes the testing step.

Examples of embodiments of the present invention will now be described with reference to the drawings, in which:-
Fig. 1 is an overall flow diagram illustrating a process for making integrated circuits according to the present invention;
Fig. 2 is an illustration of a prior art flip-chip device;
Fig. 3 is an illustration of a preferred embodiment of a flip-chip device according to a preferred embodiment of the invention;
Fig. 4 is an illustration of a flip-chip under test;
Fig. 5 is an illustration of a completed flip-chip device in a package.

### DESCRIPTION OF THE PREFERRED EMBODIMENTS

As process geometries continue to reduce, many existing devices are becoming bond pad limited. This, in conjunction with the demand for more pins on a device, is forcing the semiconductor industry to consider the use of the flip-chip assembly technique. The flip-chip assembly technique allows bond pads to be distributed in an array across the face of a die instead of arranging such bond pads in a padring around the periphery of the chip. This process greatly increases the number of contact points possible for interface with a given die, and allows full advantage to be taken of migration to smaller geometry processes in the future.

Flip-chip technology does, however, pose challenges to the wafer level testing of such products. The existing technique of using a probe card with probe needles will normally only work around the perimeter of the die. State-of-the-art membrane probers are normally used in most flip-chip processes today to access bond pads scattered across the whole die. The present invention provides solutions to present challenges with testing technology for flip-chip devices.

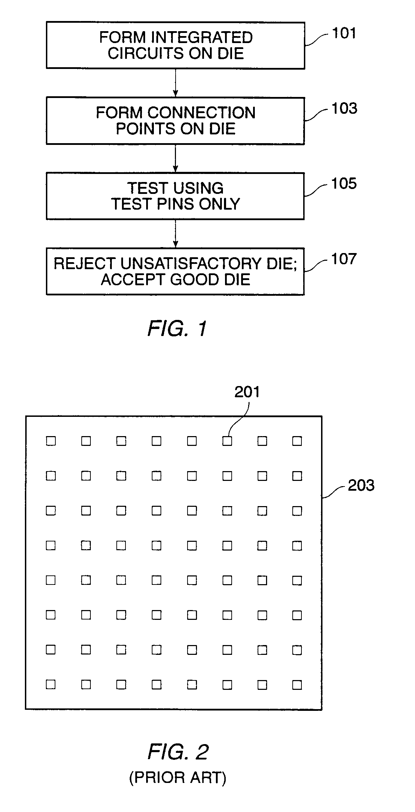

Fig. 1 illustrates an overall process for making an integrated circuit according to one embodiment of the invention. At step 101 integrated circuits are formed on a plurality of die on a wafer. According to a preferred embodiment the integrated circuit will be of a type that can be largely or fully tested without access to all of the contact points on the integrated circuit. Integrated circuits formed according to the present embodiment may take a variety of forms including, but not limited to, memories, microprocessors, DSPs, and ASICs. Specific examples of such integrated circuits are a programmable logic devices (or PLDs) and gate arrays, or any other JTAG boundary scan device. Programmable logic devices (sometimes referred to as a PALs, PLAs, FPLAs, PLDs, EPLDs, EEPLDs, LCAs, or FPGAs), are well know integrated circuits that provide the advantages of fixed integrated circuits with the flexibility of custom integrated circuits. Such devices allow a user to electrically program standard, off-the-shelf logic elements to meet the users specific needs. See, for example, U.S. Patent No. 4,617,479, incorporated herein by reference for all purposes. Such devices are currently represented by, for example, Altera's MAX^{R} series of PLDs and FLEX™ series of PLDs. The former are described in, for example, the Altera Data Book, September 1991, incorporated herein by reference for all purposes. The latter are described in, for example, U.S. Patent No. 5,260,611, and incorporated herein by reference for all purposes.

At step 103 connection points or "contact bumps" are formed on the die according to well-known techniques through electroplating. In one embodiment, this step provides for the formation of interconnection lines from selected ones of the contact bumps to peripheral contact points or probe pads, or the lines and test pads may be formed with conventional metalization techniques. The solder bumps may be added before or after test, but are preferably after test using electroplating techniques. The contact bumps and/or interconnection lines may be formed of, for example, solder, gold, aluminum, alloys, or other materials according to well-known techniques such as electroplating. Such flip-chips are later separated from each other according to well-known techniques. In an alternative embodiment of the present invention, step 103 may only provide formation of interconnection lines from the die contacts to probe pads, and testing in step 105 may proceed before forming the contact bumps on the die contacts.

At step 105 the die is tested using a conventional testing technique, except that only the peripheral probe pads are contacted during testing. In testing, for example, a programmable logic device, the device can be effectively fully tested through use of only a small part of the user I/O. In a typical testing scenario, a configuration is loaded into the device under test using, for example, a serial data input stream. Inputs are applied to the device at only selected ones of the I/O pins of the device. Additional configurations and/or user inputs are then applied to the device. Through appropriate selection of the inputs and the configuration of the device it becomes possible to test the functionality of most of the chip including logic elements, user programmable RAM, etc, on the chip. Through use of the probe pads connected to only selected user inputs, it becomes possible to select all of the functionality of a typical device except I/O buffers and TTL input buffers in part because signals may be rerouted to internal portions of the device by appropriate programming. Even functionality of a portion of the I/O blocks may be tested on such a device.

At step 107, die that do not pass selection criteria in the tester are appropriately marked and removed from the manufacturing process. Die that do pass the section criteria in the tester are passed on for further processing, solder bump formation, packaging, and sale.

Fig. 2 illustrates a typical flip-chip according to the prior art. As shown, connection points 201 (typically solder bumps) are formed in an array across a face of die 203. Such devices are not compatible with conventional test equipment, which provides for a ring-shaped array of contacts to a periphery of the device.

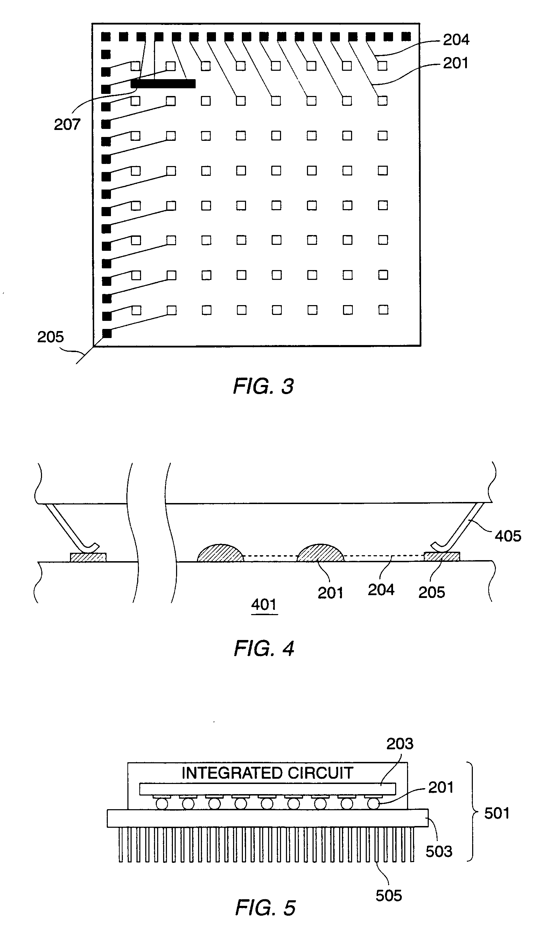

Fig. 3 illustrates a flip-chip device according to the present invention. As shown, the device still continues to provide connection points or solder bumps 201 across the face of the die 203. In addition, metallic connection lines 204 are connected to selected ones of the solder bumps 201 and extend between other solder bumps 201 (without contacting such other solder bumps 201) to a periphery of the device. At the periphery of the device, a plurality of test connection points 205 are formed. Fig. 3 is not drawn to scale. Test connection points 205 are typically much larger than solder bumps 201. For example, test connection points 205 may have a center-to-center pitch of 0.0043" whereas the pitch for solder bumps 201 may be smaller (e.g., 0.006"), but the pad size is much smaller. The test pads may be, e.g., 100x100 µm and the solder bumps will be about 50x50 µm in one specific embodiment. Using the larger test connection points 205 to contact the probe needles allows for greater error in aligning the probe card versus connecting directly to the solder bumps 201. Also, thicker probe needles may be used, due to the larger pitch, which add to the probe-card durability. The test connection points 205 are ohmically connected to the selected solder bumps 201 via the connection lines 204.

As shown, the test connection points are arranged in the form of a partial ring that is compatible with the probes on a conventional prober. While a partial ring of test connection points 205 is shown, a full ring or any variation of a partial ring may be used. Using a partial ring (such as on only two sides of the die) can save die size. The wafer space needed for the test connection points 205 that is saved by using only a partial ring may be used for other purposes, such as forming more die on the wafer. Also, while the test connection points 205 shown in Fig. 3 form a partial ring around the periphery of the device, it is also possible for such test points to form a ring or a partial ring in an internal portion of the device based upon the needs of the particular prober to be used.

In, for example, a programmable logic device, the connections to the solder bumps include selected I/O lines, any special test mode pins, and programming pins required during the wafer test procedure. Other connections would include power supplies required to operate the device, and the like.

The chip would also contain a further set of pins that are interfaced with the user I/O. This could be done through the JTAG (Joint Test Action Group) interface block 207. JTAG interface block 207 is a block of logic having three dedicated pins and an optional fourth pin. JTAG interface block 207 is shown in Fig. 3 in a representative sense, it is not typically physically formed on the face of the device. In JTAG testing, a series of devices are loaded with data and tested via a load mode, a scan mode, etc. Also, a specially designed interface for high speed operations (such as where input/output pins are used to parallelize the programming of data for test) will provide interface for high speed operations that JTAG will not be fast enough to run. Of course, other test standards may be used for PLDs or other devices.

Fig. 4 illustrates the device in a wafer during the testing process in greater detail. As shown, test device 401 provides a plurality of probe contacts 405 that extend in a resilient fashion from the test device.

Probe contacts 405 are arranged to come in contact with test connection points 205, but not to solder bumps 201. Test connection points 205 provide ohmic contact to selected ones of the solder bumps 201 through connection lines 204.

Fig. 5 illustrates the device after testing, in place in an optional package 501. It will be recognized by those of skill in the art that packages of a wide variety of package types may be used according to some embodiments of the invention including, but not limited to, PGA and BGA (pin grid array or ball grid array). Also, flip-chip assemblies are sometimes used directly on a PCB without placement in a separate package. The package may be a single chip package or a more complex package such as a multichip module of the type known to those of skill in the art. The die 203 is placed such that solder bumps 201 contact selected locations in the package substrate 503. Lines run from the package to other die in the package and/or to external connection pins 505 for insertion into a socket.

The above description is illustrative and not restrictive. Many variations of the invention will become apparent to those of skill in the art upon review of this disclosure. The scope of the invention should, therefore, be determined not with reference to the above description, but instead should be determined with reference to the appended claims along with their full scope of equivalents.

## Claims

1. A method of making an integrated circuit, said method comprising the steps of:
forming a plurality of die in a wafer, said die comprising an array of connection points in a flip-chip configuration;
forming a connection to a portion of said connection points in a die with a wafer prober, said portion of said connection points arranged in a periphery of said connection points; and
testing said die, said die selected if it passes said testing step.

2. The method recited in claim 1 wherein said connection points in said flip-chip comprise a 2-dimensional array of connection points, and further comprising the step of forming connections from peripheral test points to selected ones of said 2-dimensional array of connection points.

3. The method recited in claim 1 or 2 wherein said step of forming die on a wafer comprises forming microprocessors.

4. The method recited in any preceding claim wherein said step of forming die on a wafer comprises forming digital signal processors.

5. The method recited in any preceding claim wherein said step of forming die on a wafer comprises forming ASICs.

6. The method recited in any preceding claim wherein said step of forming die on a wafer comprises forming programmable logic devices.

7. The method recited in any preceding claim wherein said step of forming die on a wafer comprises forming memory devices.

8. The method recited in any preceding claim wherein said step of testing said die comprises testing said die before said connection points are formed into contact bumps.

9. The method recited in any preceding claim wherein said step of testing said die comprises rerouting signals impressed upon a portion of said connection points to internal portions of said die, said rerouting comprising programming said die appropriately.

10. A method of making an integrated circuit, said method comprising the steps of:
forming a plurality of die in a wafer, said die comprising an array of connection points in a flip-chip configuration;
forming a plurality of test points on said wafer, said test points being larger than said connection points;
forming a connection from a portion of said connection points to a portion of said test points;
forming a connection to a portion of said test points with a wafer prober;
testing said die, said die selected if it passes said testing.

11. The method recited in claim 10 wherein said step of forming a plurality of test points comprises forming a plurality of test points about a periphery of said connection points.

12. The method recited in claim 10 wherein said connection points comprise a 2-dimensional array of connection points, and said step of forming a plurality of test points comprises forming at least a portion of said test points within a periphery of said 2-dimensional array.

13. A system for testing die on a wafer, said system comprising:
a die on a wafer, said die comprising an array of connection points in a flip-chip configuration;
a plurality of test points, a portion of said test points coupled to a portion of said connection points, said portion of test points arranged according to a layout for coupling to a wafer prober;
a wafer prober for electrically coupling to said portion of test points; and
an analyzer electrically coupled to said wafer prober for testing said die, said die selected if it passes said testing.

14. The system recited in claim 13 wherein said test points are arranged about a periphery of said connection points.

15. The system recited in claim 13 wherein said array of connection points comprises a 2-dimensional array, and wherein a portion of said test points are disposed within a periphery of said 2-dimensional array of connection points.

16. The system recited in any one of claims 13 to 15 wherein said test points are larger than said connection points.

17. The system recited in any one of claims 13 to 16 wherein said die comprises a microprocessor.

18. The system recited in any one of claims 13 to 17 wherein said die comprises a digital signal processor.

19. The system recited in any one of claims 13 to 18 wherein said die comprises an ASIC.

20. The system recited in any one of claims 13 to 19 wherein said die comprises a programmable logic device.

21. The system recited in any one of claims 13 to 20 wherein said die comprises a memory device.
